# EUROPEAN PATENT APPLICATION

(11) **EP 4 546 964 A1**
(43) Date of publication of application: **30.04.2025**
(21) Application number: 24207286.6
(22) Date of filing: 17.10.2024
(51) Int. Cl.: H05K 7/18, H04B 1/38, H04B 1/03, H01Q 1/24, H04B 1/08

(54) **AN APPARATUS FOR A TELECOMMUNICATIONS NETWORK**

(30) Priority: 27.10.2023 GB 202316455
(71) Applicant: euNetworks Group Limited, London E14 5HU (GB)
(72) Inventor: Gierth, Mathias, 13509 Berlin (DE)
(74) Representative: Beck Greener LLP

(57) **Abstract**

The present invention provides an apparatus for a telecommunications network, comprising a housing having a plurality of user compartments and at least one host compartment; wherein each of the plurality of user compartments is configured to house one or more user equipment; wherein the at least one host compartment is configured to house an optical fibre device for receiving input signals from the user equipment and to output corresponding signals for transmission over one or more optical fibres connected thereto; wherein the apparatus is configured to house an antenna to be communicatively coupled with the one or more user equipment housed in one or more of the plurality of user compartments, the antenna being configured to receive wireless communication signals and to communicate the received wireless communication signals to the one or more user equipment; wherein the apparatus is configured to house a power supply device for providing power to the antenna, the optical fibre device, and the one or more user equipment.

## Description

The present invention relates to an apparatus for a telecommunications network.

In embodiments, the present invention relates to a housing or enclosure in which shared resources may be provided for the deployment of telecommunication network equipment. In embodiments, the present invention also relates to an apparatus comprising said shared resources.

In telecommunications, such as in 4G or 5G mobile communications networks, signal masts are typically put up to relay signals between user devices and the wider communications network. A signal mast usually has a number of antennas, connected to other electronic components, and is usually placed in an elevated position to maximise the reach of the antennas. In urban areas, this may mean positioning masts on roof tops of houses and buildings. There are however also drawbacks in positioning masts on roof tops. One such drawbacks is dead zones.

A dead zone is effectively an area of low elevation, such as at street level, created by shadows of surrounding buildings, not reached by any signal masts. These areas are problematic as user devices located in these areas would be unable to connect to a telecommunications network and user devices traversing through these areas would experience a loss of connection. This is undesirable as for many types of user devices, including mobile telephones, computers, smart meters, autonomous vehicles, or any device that requires a mobile internet connection, a stable and reliable connection is paramount.

As an example, a mobile phone user traversing on foot whilst conducting a telephone call would require a stable and uninterrupted network connection. Passing through a dead zone would cause an undesirable loss of connection and termination of the telephone call. As another example, an internet enabled smart vehicle may require a constant, uninterrupted internet connection in order to function properly and safely. A loss of internet connection caused by traversing through a dead zone may cause the vehicle to lose certain functionality, which may be undesirable as well as unsafe.

As yet another example, so-called "smart meters" are electricity and/or gas meters that are installed at the location of consumers and connect directly to the suppliers over a mobile internet connection. Meter readings for the calculation of energy consumption and bills are communicated to energy suppliers over the mobile internet connection. Such smart meters have become more and more wide spread and are increasingly being promoted by governments as a way to encourage more efficient and environmentally friendly consumption of energy. However, for premises (domestic, commercial, or otherwise) located in a dead zone, the lack of a stable or any wireless internet connection presents a challenge and may be a barrier to the implementation of smart meters at these premises.

There is therefore a need for an apparatus to enable network operators to connect user devices in dead zones to telecommunication networks.

A conventional street side cabinet for telecommunication applications is typically a metal enclosure with doors for access and security. The enclosure provides space for telecommunications equipment, such as telephone and internet exchange equipment, and provides means such as cables to connect the exchange equipment to the networks of telephone and internet service providers. The enclosure also provides means such as cables to connect the exchange equipment to premises (domestic, commercial, or otherwise), thereby enabling user devices (such as computers, mobile phones, or other communication devices) in those premises to connect to telephone and internet networks.

According to the first aspect of the present invention, there is provided an apparatus for a telecommunications network, comprising a housing having a plurality of user compartments and at least one host compartment; wherein each of the plurality of user compartments is configured to house one or more user equipment; wherein the at least one host compartment is configured to house an optical fibre device for receiving input signals from the user equipment and to output corresponding signals for transmission over one or more optical fibres connected thereto; wherein the apparatus is configured to house an antenna to be communicatively coupled with the one or more user equipment housed in one or more of the plurality of user compartments, the antenna being configured to receive wireless communication signals and to communicate the received wireless communication signals to the one or more user equipment; wherein the apparatus is configured to house a power supply device for providing power to the antenna, the optical fibre device, and the one or more user equipment.

The apparatus of the present invention enables multiple users to deploy user equipment and use shared resources provided in the apparatus in dead zones not reached by convention signal masts. The apparatus also enables multiple users to connect user equipment deployed in dead zone to optical fibre networks and data centres of network operators. Providing shared resources in this manner also affords users or the host of the apparatus easy scalability. For example, a user can simply add more pieces of user equipment into the apparatus to increase capacity or functionality, and vice versa. Similarly, a host can simply add additional optical fibre devices and/or antennas to expand the capabilities of the apparatus. The apparatus of the present invention also functions effectively as a mobile tower, but in a much more discrete and inconspicuous manner.

In embodiments, the apparatus has a main opening configured to provide access to the at least one host compartment and the plurality of user compartments, wherein the main opening is lockable to prevent unauthorized access.

In embodiments, each user compartment has a compartment opening through which user equipment is received, wherein the compartment opening is lockable to prevent unauthorized access to user equipment received in the user compartment.

In embodiments, the at least one host compartment has a lockable door to prevent unauthorized access to a space therein.

In embodiments, each user compartment includes one or more power connection points configured to connect the user equipment housed therein to the power supply device housed in the apparatus.

In embodiments, each user compartment includes one or more data connection points configured to communicatively connect the user equipment housed therein to the optical fibre device housed in the apparatus.

According to the second aspect of the present invention, there is provided an apparatus for a telecommunications network, comprising a housing having a plurality of user compartments and at least one host compartment, wherein each of the plurality of user compartments is configured to house one or more user equipment; an optical fibre device disposed in the at least one host compartment, communicatively coupled to the one or more user equipment, and configured to receive input signals from the one or more user equipment and to output corresponding signals for transmission over one or more optical fibres connected thereto; an antenna disposed in the at least one host compartment, communicatively coupled with the one or more user equipment, configured to receive wireless communication signals and to communicate the received wireless communication signals to the one or more user equipment; and a power supply device disposed in the at least one host compartment, configured to provide power to the antenna, the optical fibre device, and the one or more user equipment.

In embodiments, the apparatus further comprises one or more optical fibre cables configured to communicatively coupled to an optical fibre device housed in the host compartment and to connect the apparatus to an external data centre.

In embodiments, the apparatus further comprises cooling means disposed in the at least one host compartment.

In embodiments, the apparatus further comprises comprising cooling means disposed in each of the user compartments.

In embodiments, the antenna is configured to receive 5G communication signals.

In embodiments, the optical fibre device includes an optical distribution frame.

In embodiments, the apparatus is adapted to be installed on street pavements.

Embodiments of the present invention will hereinafter be described by way of examples, with references to the accompanying drawings, in which:
Figure 1 is a perspective view of an apparatus for a telecommunications network;
Figure 2 is another perspective view of an apparatus for a telecommunications network;
Figure 3 is yet another perspective view of an apparatus for a telecommunications network;
Figure 4 is a perspective view of another apparatus for a telecommunications network.

The present invention provides an apparatus for a telecommunications network. The apparatus generally comprises a housing (or, synonymously, an enclosure) that is divided into a number of compartments, including a number of user compartments. Each of the user compartments is configured to receive and house user equipment from a user of the apparatus. A user is typically a telecommunication service provider or a network operator, and the apparatus provides connections to connect the user equipment housed in the apparatus to shared resources disposed in the apparatus. The apparatus may be installed on street sides such as on pavements/sidewalks, in particular in dead zone not reached or covered by signal masts, inside a building located within a dead zone, or other public places where data needs to be collected or shared, thereby providing shared resources for different users to deploy user equipment in those areas. Telecommunication networks may include data centres, operated by service providers or network operators, for receiving and processing communication signals and data. In that context, the apparatus may also be connected to those data centres, over an optical fibre network for example, thereby connecting user equipment housed in the apparatus to those data centres.

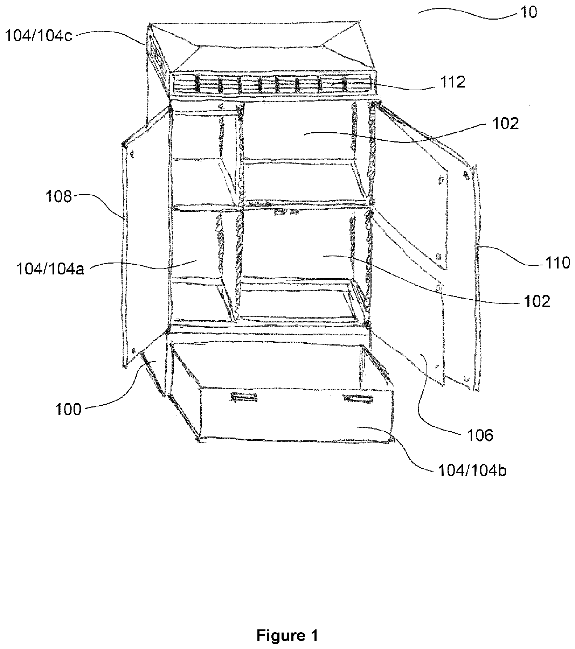

In embodiments exemplified by figure 1, the apparatus 10 comprises a housing or an enclosure 100 that is divided into a plurality of compartments, including a plurality of user compartments 102 and a plurality of host compartments 104. Each user compartment 102 provides space for receiving user equipment from a user and is configured to connect the user equipment housed in the apparatus to an antenna, optical fibre device, and power supply device received and housed in the apparatus 10. A user compartment 102 may have shelves, racks, or other means to facilitate a user to arrange one or more pieces of user equipment within the user compartment 102. The user compartments 102 are also configured so that pieces of user equipment housed in the apparatus 10 connect to the same antenna, optical fibre device, and power supply device. For example, in some embodiments, each user compartment 102 includes various connection points, including power connection points and data connection points, for connecting any user equipment housed in the user compartment 102 to the same antenna, optical fibre device, and power supply device. In some embodiments, each user compartment 102 alternatively or additionally includes portals through which appropriate cables may be deployed to connect any user equipment housed in the user compartment 102 to the same antenna, optical fibre device, and power supply device. With these arrangements, user equipment housed in different user compartments 102 are able to utilise the share resources, i.e. the antenna, optical fibre device, and power supply device, that the apparatus 10 provides. In particular, users of the apparatus 10 may be different mobile network operators, each taking up one user compartment 102. The present arrangement therefore enables different network operators to deploy user equipment within the same apparatus 10 and to utilise shared resources that the apparatus 10 provides. In the particular embodiment shown in figure 1, the apparatus 10 is configured with two user compartments 102. It will however be appreciated that other embodiments of the apparatus 10 may have any other number of user compartments 102 or just a single user compartment 102.

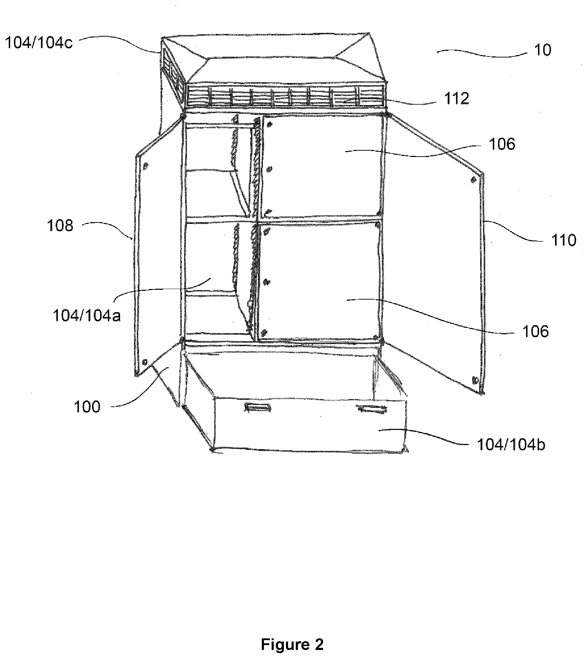

In various embodiments, each user compartment 102 has an opening to allow an authorized user to access the space inside, to install and/or service user equipment for example. In embodiments, each user compartment 102 further includes means of closure 106, such as a door, which may also be lockable, to allow an authorized user to secure the space inside against unauthorized access whilst allowing the authorized user to access the space. In such an arrangement, a first user having been granted use of a first user compartment 102 may be able to install equipment into the first user compartment 102 and lock the first user compartment 102 to prevent a second user, who may have been granted user of a second user compartment 102, to access the first user compartment 102. In some embodiments, each user compartment 102 may include a door 106 that is equipped with a built-in lock. The lock may be a key operated lock, a combination lock, fingerprint recognition lock, other forms of electronic or mechanical lock, or any other suitable kind of lock known to the skilled person. In some other embodiments, the door 106 may include a latch or similar arrangements that is capable of accepting a lock, such as a padlock. Figure 1 shows the door 106 of each user compartment 102 in an open position. Figure 2 shows the doors 106 in a closed position preventing access into the space of the user compartments 102.

Referring still to figure 1, the housing 100 of the apparatus 10 of various embodiments further includes one or more host compartments 104. As depicted, the apparatus 10 of the embodiment of figure 1 has three host compartments 104. It will however be appreciated that various embodiments may have only one host compartment 104 or any other number of host compartments 104. Each host compartment 104 provides space for receiving one or more pieces of equipment from a host, typically the proprietor of the apparatus 10, for use as shared resources. In the embodiment of figure 1, the apparatus 10 includes a first host compartment 104a, a second host compartment 104b, and a third host compartment 104c.

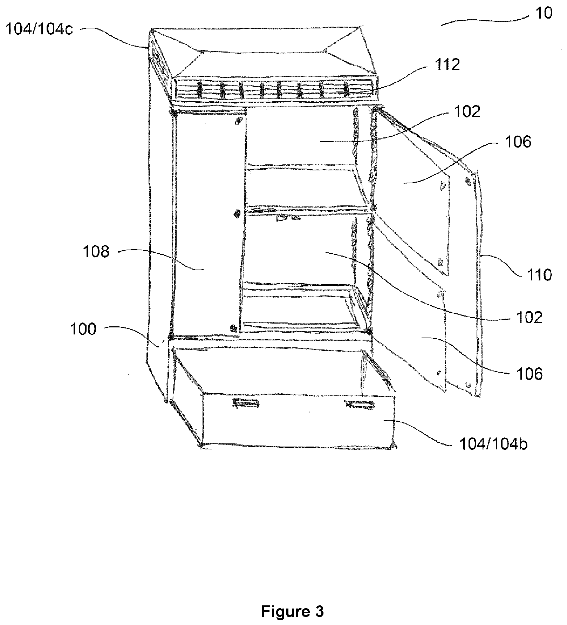

The first host compartment 104a is configured to receive and house an optical fibre device, one function of which is to receive input signals from any user equipment that is connected thereto and to process those input signals into optical outputs. The optical outputs may then be communicated to various data centres via optic fibre cables. Another function of the optical fibre device is to receive optical input signals from various data centres via optic fibre cables, process those optical input signals into electrical outputs, and communicate those electrical outputs to the user equipment that is connected thereto. In some embodiments, the first host compartment 104a includes data connection points to facilitate the connection with any user equipment housed in the one or more user compartments 102. In some embodiments, the first host compartment 104a alternatively or additionally includes portals through which appropriate cables may be deployed to facilitate the connection with any user equipment housed in the one or more user compartments 102. In various embodiments, the first host compartment 104a has an opening to allow the host of the apparatus 10 to access the space inside the first host compartment 104a, to install and/or service the optical fibre device for example. In embodiments, the first host compartment 104a further includes means of closure, such as a door 108, which may also be lockable, to allow the host to secure the space inside the first host compartment 104a against unauthorized access. Similar to the door 106 of the one or more user compartments 102, the door 108 of the first host compartment 104a may also be equipped with a built-in lock such as a key operated lock, a combination lock, fingerprint recognition lock, other forms of electronic or mechanical lock, or any other suitable kind of lock known to the skilled person. In some other embodiments, the door 108 of the first host compartment 104a may similarly include a latch or similar arrangements that is capable of accepting a lock, such as a padlock. Figure 1 shows the door 108 of the first host compartment 104a in an open position. Figure 3 shows the doors 108 in a closed position preventing access into the space of the first host compartment 104a.

The apparatus 10 is also generally configured to receive and house a power supply device for supplying electrical power to any electrical equipment received and housed in the apparatus 10, including the antenna, user equipment, and optical fibre device. In various embodiments, including the embodiment shown in figure 1, the second host compartment 104b provides space therein that is configured to receive and house a power supply device for providing power to any electrical equipment housed in the apparatus 10, in particular to any user equipment housed in any of the user compartments 102 of the housing 100. The power supply device may be configured to receive mains electricity from an external supply and to distribute the received electricity in AC, DC, or both to various electrical equipment housed in the apparatus 10. The second host compartment 104a also includes connection points and/or portals through which appropriate electrical cables may be deployed to facilitate the connection between any electrical equipment housed in the one or more user compartments 102 and the power supply device. In various embodiments, the second host compartment 104b similarly has an opening to allow the host of the apparatus 10 to access the space inside, to install and/or service a power supply device for example. In embodiments, the second host compartment 104b further includes means of closure similar to those of the first host compartment 104a. In some embodiments, the second host compartment 104b is configured as a drawer that slides outwards to provide access to the space therein and slides inwards to close the drawer. In some of these embodiments, the second host compartment 104b may further include means for locking the drawer similar to those described above.

In various use cases, the power supply device itself does not generate electricity. In various embodiments, the apparatus 10 includes connection points to facilitate the connection of the power supply device to an external power source (e.g. mains power source) to receive electrical power. In some embodiments, the apparatus 10 alternatively or additionally includes portals through which appropriate cables may be deployed to facilitate the connection of the power supply device to an external power source. In turn, the power supply device distributes the received electrical power to any electrical equipment housed in the apparatus 10. In particular, the power supply device may step up or down the voltage of the received electrical power and may convert the received electrical power into AC or DC before distributing to electrical equipment housed in the apparatus 10.

The apparatus 10 is also generally configured to receive and house an antenna, or similar telecommunication devices known to the skilled person, which is at least configured to receive and transmit data and/or telecommunication signals, such as 4G, 5G, or WiFi signals, or any other forms of communication signals, from and to user devices, including mobile telephones, computers, smart meters, autonomous vehicles, or any device known to the skilled person that is capable of establishing a mobile internet connection. The antenna is also configured to communicate telecommunication signals received from user devices to any user equipment that is housed in the apparatus 10 and connected thereto, and to receive telecommunication signals from any user equipment connected thereto and to transmit those telecommunication signals to nearby user devices. In various embodiments, including the embodiment shown in figure 1, the third host compartment 104c provides space therein that is configured to receive and house such an antenna. The antenna may be any that is suitable and known to the skilled person. In various embodiments, the third host compartment 104c includes connection points to facilitate the connection of the antenna to any user equipment housed in the any of the user compartments 102. Alternatively or additionally, the third host compartment 104c includes portals through which appropriate cables may be deployed to connect any user equipment housed in any of the user compartments 102 to the antenna. This arrangement allows the same antenna to be shared amongst all the user equipment that are housed in the apparatus 10. In some further embodiments, a user may install a separate antenna alongside any user equipment to supplement the antenna provided in the apparatus 10. A user may wish to install a separate, more dedicated antenna to receive and transmit signals or signal types that the antenna provided in the apparatus is not able to handle.

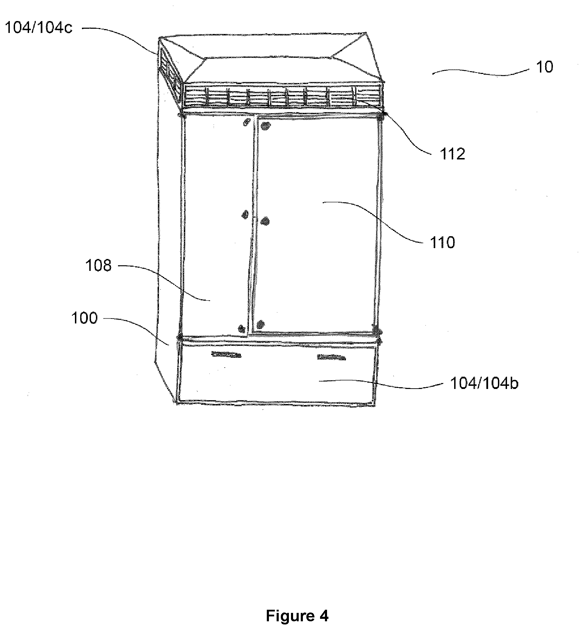

Referring still to Figure 1, the housing 100 of various embodiments of the apparatus 10 further includes external means of closure 110, such as an external door, that can be closed, and which may also be lockable, to prevent unauthorised access to the interior of the apparatus 10 where user equipment, the optical fibre device, the power supply device, and the antenna are received and housed. In some embodiments, the external door 110 is similarly equipped with a built-in lock. The lock may similarly be a key operated lock, a combination lock, fingerprint recognition lock, other forms of electronic or mechanical lock, or any other suitable kind of lock known to the skilled person. In some other embodiments, the external door 110 may similarly include a latch or similar arrangements that is capable of accepting a lock, such as a padlock. Figure 1 shows the external door 110 in an open position. Figure 4 shows the external door 110 in a closed position along with the doors 106 of the user compartments 102 (not visible) and the door 108 of the first host compartment 104a.

In various embodiments, the apparatus 10 is further configured to receive and house cooling means, such as electric fans, for cooling any electrical equipment housed in the apparatus 10. The cooling means may be housed in one or more of the user compartments 102, one or more of the host compartments 104, or a combination thereof. In embodiments where the cooling means require electric power, the cooling means may also be electrically connected to the same power supply device as other electrical equipment in the apparatus 10. In some embodiments, the apparatus 10 additionally include vent openings 112 for airflow to facilitate cooling of electrical equipment in the apparatus 10.

As shown in figure 1 and described above, the housing 100 of the apparatus 10 is provided with three host compartments 104, respectively configured to receive and house an optical fibre device, a power supply device, and an antenna. It will however be appreciated that the housing 100 of embodiments of the apparatus 10 may have any number of host compartments 104 and the optical fibre device, power supply device, and antenna may be housed in any one or more host compartments 104.

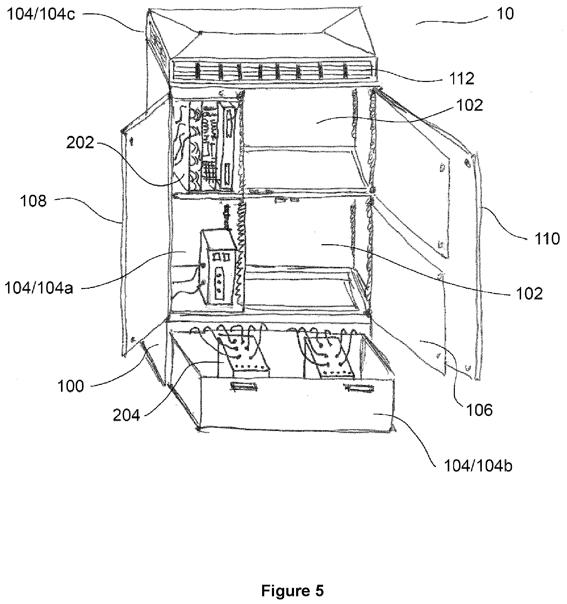

The present invention is also directed to an apparatus 10 that includes the housing 100 of the various embodiments described hereinabove and shared resources disposed therein. In various embodiments, such as that shown in Figure 5, the apparatus 10 includes a housing 100 that is similarly divided a plurality of user compartments 102 and host compartments 104. In the particular embodiment of Figure 4, the housing 100 is divided into two user compartments 102 and three host compartments 104, similar to the housing 100 depicted in Figure 1. An optical fibre device 202 as per the disclosure hereinabove, which may include an optical distribution frame, is disposed in the first host compartment 104a. A power supply device 204 as per the disclosure hereinabove, which may be a transformer and/or power management device, is disposed in the second host compartment 104b. An antenna 206 as per the disclosure hereinabove, which may be a 4G and/or 5G antenna, or any other suitable antenna known to the skilled person, is disposed in the third host compartment 104c. Each of the user compartments 102 and host compartments 104 is provided with portals through which wires and cables may be threaded to facilitate data, power, and other connections between user equipment and the shared resources. In some embodiments, the user compartments 102 and host compartments 104 may be provided with connection points as per the disclosure hereinabove. The apparatus 10 may also be provided with portals and/or connection points for connecting the power supply device 204 to an external source of electrical power such as mains electricity supply. In embodiments, the apparatus 10 includes portals and/or connection points to facilitate the connection of the optical fibre device 202 to an external optical fibre network, which may in turn be connected to one or more data centres of one or more network operators.

In some embodiments, the antenna 206 may be a Multi-In-Multi-Out antenna. Using such an antenna has the benefits of minimizing errors and increasing speed/efficiency/capacity, amongst others.

In use, when the apparatus 10 is installed in a desired location, with user equipment installed and appropriately connected, the apparatus 10 enables network operators to deploy user equipment in dead zones using shared resources provided in the apparatus 10. The antenna 206 receives communication signals from various mobile internet enabled user devices and communicates those signals to the user equipment. The optical fibre device 202 converts analogue signals into optical outputs and communicates the optical outputs through an external optical fibre network to data centres of network operators. Vice versa, telecommunication signals may be communicated from data centres of network operators to the apparatus 10 over the external optical fibre network, converted into electromagnetic wave outputs by the optical fibre device 202 and communicated the user equipment for processing. The user equipment may then communicate signals to the antenna 206, which in turn transmits signals to user devices.

Using shared resources in this manner enables different network operators to use the same apparatus 10, thereby avoiding the need to install separate enclosures, each with separate power supplies and optical distribution frames. It also enables a host to manage the apparatus 10 effectively and efficiently for multiple users. This arrangement also requires less infrastructure whilst enabling multiple network operators to operate in a dead zone more effectively and efficiently.

In the embodiment shown in Figure 5, the third host compartment 104c, with the antenna 206 disposed therein, is arranged at a top portion of the housing 100 and the second host compartment 104b, with the power supply device 204 disposed therein, is arranged at a bottom portion of the housing. Positioning the third host compartment 104c near the top of the housing 100 places the antenna 206 at a height similar to the height at which a mobile phone might be held when in use. Positioning the second host compartment 104b at the bottom portion of the housing places the power supply device 204 nearer the ground when the apparatus 10 is installed to avoid the necessity of long wires to connect the power supply device 204 to an external electrical power source.

In various embodiments, the housing 100 of the apparatus 10 may be made primarily of a metal or alloy, such as steel, sheet steel, or other suitable sheet metal. In some embodiments, the housing 100 may be made of a polycarbonate material. In some other embodiments, the housing 100 may be made of a combination of metal, alloy, polycarbonate, and any other suitable material known to the skilled person. The housing 100 may be formed as a single unit or as a modular assembly. In some embodiments, in which the housing 100 is modular, the user compartments 102 and the first host compartment 104a may be formed as one unit, the second host compartment 104b as another unit, the third host compartment another unit 104c, and the units may be assembled using various suitable means known to the skilled person, such as screws or nuts and bolts.

Embodiments of the present invention have been described with particular reference to the examples illustrated. However, it will be appreciated that variations and modifications may be made to the examples described within the scope of the appending claims.

## Claims

1. An apparatus for a telecommunications network, comprising:
a housing having a plurality of user compartments and at least one host compartment;
wherein each of the plurality of user compartments is configured to house one or more user equipment;
wherein the at least one host compartment is configured to house an optical fibre device for receiving input signals from the user equipment and to output corresponding signals for transmission over one or more optical fibres connected thereto;
wherein the apparatus is configured to house an antenna to be communicatively coupled with the one or more user equipment housed in one or more of the plurality of user compartments, the antenna being configured to receive wireless communication signals and to communicate the received wireless communication signals to the one or more user equipment;
wherein the apparatus is configured to house a power supply device for providing power to the antenna, the optical fibre device, and the one or more user equipment.

2. The apparatus of claim 1, wherein the apparatus has a main opening configured to provide access to the at least one host compartment and the plurality of user compartments, wherein the main opening is lockable to prevent unauthorized access.

3. The apparatus of claim 1 or 2, wherein each user compartment has a compartment opening through which user equipment is received, wherein the compartment opening is lockable to prevent unauthorized access to user equipment received in the user compartment.

4. The apparatus of any preceding claim, wherein the at least one host compartment has a lockable door to prevent unauthorized access to a space therein.

5. The apparatus of any preceding claim, wherein each user compartment includes:
one or more power connection points configured to connect the user equipment housed therein to the power supply device housed in the apparatus; and/or
one or more data connection points configured to communicatively connect the user equipment housed therein to the optical fibre device housed in the apparatus.

6. An apparatus for a telecommunications network, comprising:
a housing having a plurality of user compartments and at least one host compartment, wherein each of the plurality of user compartments is configured to house one or more user equipment;
an optical fibre device disposed in the at least one host compartment, communicatively coupled to the one or more user equipment, and configured to receive input signals from the one or more user equipment and to output corresponding signals for transmission over one or more optical fibres connected thereto;
an antenna disposed in the at least one host compartment, communicatively coupled with the one or more user equipment, configured to receive wireless communication signals and to communicate the received wireless communication signals to the one or more user equipment; and
a power supply device disposed in the at least one host compartment, configured to provide power to the antenna, the optical fibre device, and the one or more user equipment.

7. The apparatus of claim 6, further comprising one or more optical fibre cables configured to communicatively coupled to an optical fibre device housed in the host compartment and to connect the apparatus to an external data centre.

8. The apparatus of claim 6 or 7, further comprising cooling means disposed in the at least one host compartment and/or in each of the user compartments.

9. The apparatus of any of claims 6 to 8, wherein the antenna is:
configured to receive 5G communication signals; or
a Multi-In-Multi-Out antenna.

10. The apparatus of any of claims 6 to 9, wherein the optical fibre device includes an optical distribution frame.

11. The apparatus of any preceding claim, adapted to be installed on street pavements.

12. The apparatus of any of claims 6 to 11, wherein the apparatus has a main opening configured to provide access to the at least one host compartment and the plurality of user compartments, wherein the main opening is lockable to prevent unauthorized access.

13. The apparatus of any of claims 6 to 12, wherein each user compartment has a compartment opening through which user equipment is received, wherein the compartment opening is lockable to prevent unauthorized access to user equipment received in the user compartment.

14. The apparatus of any of claims 6 to 13, wherein the at least one host compartment has a lockable door to prevent unauthorized access to a space therein.

15. The apparatus of any of claims 6 to 14, wherein each user compartment includes:
one or more power connection points configured to connect the user equipment housed therein to the power supply device; and/or
one or more data connection points configured to communicatively connect the user equipment housed therein to the optical fibre device.
